# EUROPEAN PATENT SPECIFICATION

(11) **EP 3 537 162 B1**
(45) Date of publication and mention of the grant of the patent: **17.02.2021**
(21) Application number: 17867027.9
(22) Date of filing: 20.09.2017
(51) Int. Cl.: G01R 11/24, G01R 22/06, G01D 4/00, G08B 17/02, G08B 17/06

(54) **ELECTRICITY METER AND ELECTRICITY METER FIRE OUTBREAK LOCATION IDENTIFICATION METHOD**
ELEKTRIZITÄTSZÄHLER UND ELEKTRIZITÄTSZÄHLERFEUERAUSBRUCHSTANDORTIDENTIFIZIERUNGSVERFAHREN
COMPTEUR D'ÉLECTRICITÉ ET PROCÉDÉ D'IDENTIFICATION DE POSITION DE DÉBUT D'INCENDIE DE COMPTEUR D'ÉLECTRICITÉ

(30) Priority: 01.11.2016 JP 2016214656
(43) Date of publication of application: 11.09.2019
(73) Proprietor: Omron Corporation, Kyoto-shi, Kyoto 600-8530 (JP)
(72) Inventor: SATO, Masashi, Ichinomiya-shi Aichi 491-0201 (JP)
(74) Representative: Kilian Kilian & Partner
(86) International application number: PCT/JP2017/033852
(87) International publication number: WO 2018/083901

(56) References cited:
- WO-A1-2013/167165
- WO-A1-2016/181693
- WO-A1-2018/131246
- WO-A2-03/065055
- CN-U- 203 164 248
- JP-A- 2010 019 680
- JP-A- 2014 002 633
- US-A1- 2015 070 507

## Description

### Technical Field

The present invention relates to an energy meter and an energy meter fire outbreak location identification method which can prevent fraudulent activities.

### Background Art

Conventionally, there have been wrongdoers who commit electricity theft (steal electricity) by tampering with energy meters.

Electricity theft through tampering with an energy meter is committed by, for example, setting fire to the energy meter so as to delete a record of power consumption for which a user should be charged.

An energy meter is burned by, for example, (i) a method in which a display section of an energy meter, such as a liquid crystal display (LCD) display section for displaying the power consumption, is intensively burned so as to make it impossible to read the display section or (ii) a method in which an energy meter is completely burned in its entirety.

Power supply companies file claims for damages against those who have committed such fraud. In many cases, however, it is not possible to identify the amount of compensation because the evidence such as the record of power consumption is burned. In many cases of electricity theft by burning energy meters, in particular, wrongdoers make such false accusation that the energy meters caught fire from inside due to malfunction.

Conventionally, Patent Literature 1, for example, discloses an energy meter which detects a rise in a temperature of an electrically conductive section.

The energy meter disclosed in Patent Literature 1 is configured to include a temperature detecting section provided in the vicinity of the electrically conductive section and of terminal parts in the energy meter so that in a case where it is determined that temperature-related data outputted from the temperature detecting section has a certain value or more, the energy meter displays or communicates that the temperature is at a certain value or more.

This allows an administrator to recognize, through the displaying or the transmission by the energy meter, that the energy meter has reached an abnormal temperature as a result of a consumer using an electric current so as to exceed a rated electric current. Therefore, the administrator is supposedly able to find out the cause of an abnormal temperature rise before the energy meter breaks, so that it is possible to prevent (i) breakage of the energy meter and (ii) damage to an electronic device and a house, which damage results from the breakage of the energy meter

US 2015/070507 A1 discloses an energy meter with an internal and an external temperature sensor for detecting fires or overheating, but not due to tampering. WO 2013/167165 A1 shows a metering device with a single temperature sensor to detect fires, again not due to tampering with the meter. WO 03/065055 A2 relates to a metering device wherein fraudulent activity due to high magnetic interference is detected by the burning of a fuse.

### Citation List

### [Patent Literature]

### [Patent Literature 1]

Japanese Patent Application Publication, Tokukai, No. 2010-19680 (Publication Date: January 28, 2010)

### Summary of Invention

### Technical Problem

With the energy meter disclosed in Patent Literature 1, it is possible to expect, by use of a temperature which has propagated through a power supply side or a load side, a temperature rise which will lead to the breakage of the energy meter.

In reality, however, fraudulent activities of willfully burning an energy meter have been committed. Against such fraudulent activities, therefore, it is important to identify that the energy meter has been burned from outside the energy meter. However, the conventional energy meter disclosed in Patent Literature 1 unfortunately does not make it possible to determine whether fire has broken out from inside the energy meter or the fire has been set to the energy meter from outside.

The present invention has been made in view of the conventional problem, and it is an object of the present invention to provide an energy meter and an energy meter fire outbreak location identification method, each of which can (i) determine whether fire has broken out from inside the energy meter or the fire has been set to the energy meter from outside and (ii) retain the results of the determination.

### Solution to Problem

In order to attain the object, an energy meter in accordance with an aspect of the present invention is an energy meter in which power consumption is accumulated, including: a first threshold temperature detecting section configured to detect that a temperature of a first location inside an energy meter main body has become equal to or higher than a first threshold temperature which was set in advance; a second threshold temperature detecting section configured to detect that a temperature of a second location, which is located closer to a housing of the energy meter main body than is the first location, has become equal to or higher than a second threshold temperature; a determining section configured to determine, based on a result of detection by the first threshold temperature detecting section and a result of detection by the second threshold temperature detecting section, which one of the following (i) and (ii) occurred before the other: (i) the temperature of the first location became equal to or higher than the first threshold temperature and (ii) the temperature of the second location became equal to or higher than the second threshold temperature; and a transmitting section configured to transmit, to an outside entity, a result of determination by the determining section. In an aspect of the present invention, the transmitting section can transmit a result of the determination by the determining section to an outside entity, examples of the result encompassing (i) the fact that the temperature of the second location became equal to or higher than the second threshold temperature before the temperature of the first location became equal to or higher than the first threshold temperature and (ii) the fact that the temperature of the first location became equal to or higher than the first threshold temperature before the temperature of the second location became equal to or higher than the second threshold temperature. In addition, the second threshold temperature and the first threshold temperature can be identical or different.

In order to attain the object, an energy meter fire outbreak location identification method in accordance with an aspect of the present invention is a method of identifying whether a fire outbreak location of an energy meter in which power consumption is accumulated is (i) a first location inside an energy meter main body or (ii) a second location located closer to a housing of the energy meter main body than is the first location, including the steps of: (a) detecting that a temperature of the first location of the energy meter main body has become equal to or higher than a first threshold temperature which was set in advance; (b) detecting that a temperature of the second location of the energy meter main body has become equal to or higher than a second threshold temperature which was set in advance; (c) determining which one of the following (i) and (ii) occurred before the other: (i) the temperature of the first location became equal to or higher than the first threshold temperature and (ii) the temperature of the second location became equal to or higher than the second threshold temperature; and (d) transmitting, to an outside entity, a result of the step (c).

### Advantageous Effects of Invention

With an aspect of the present invention, it is advantageously possible to provide an energy meter and an energy meter fire outbreak location identification method, each of which can (i) determine whether fire has broken out from inside the energy meter or the fire has been set to the energy meter from outside and (ii) retain the results of the determination.

### Brief Description of Drawings

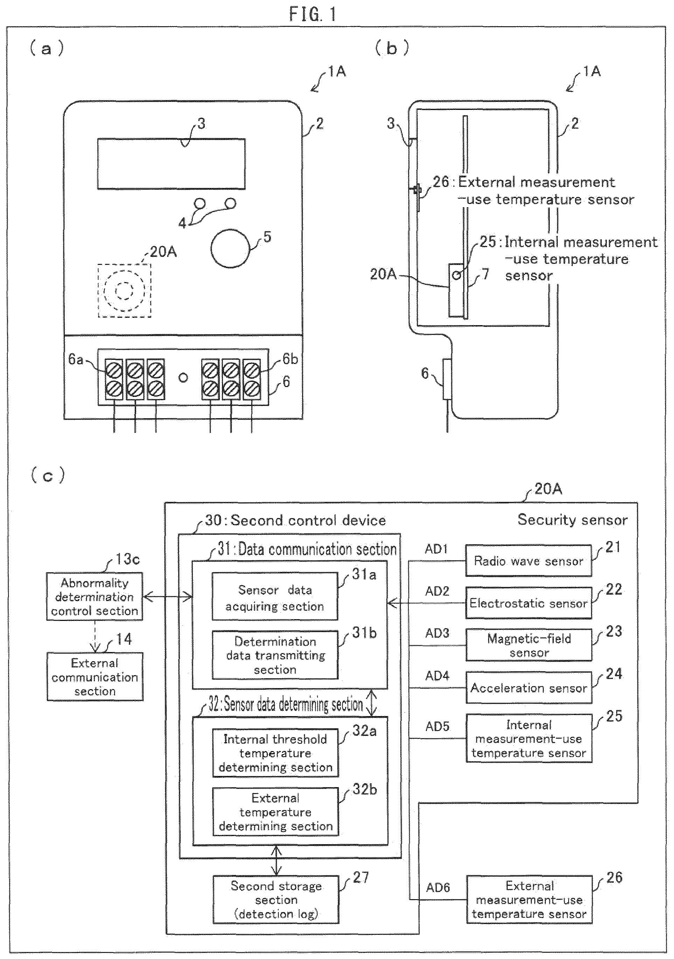

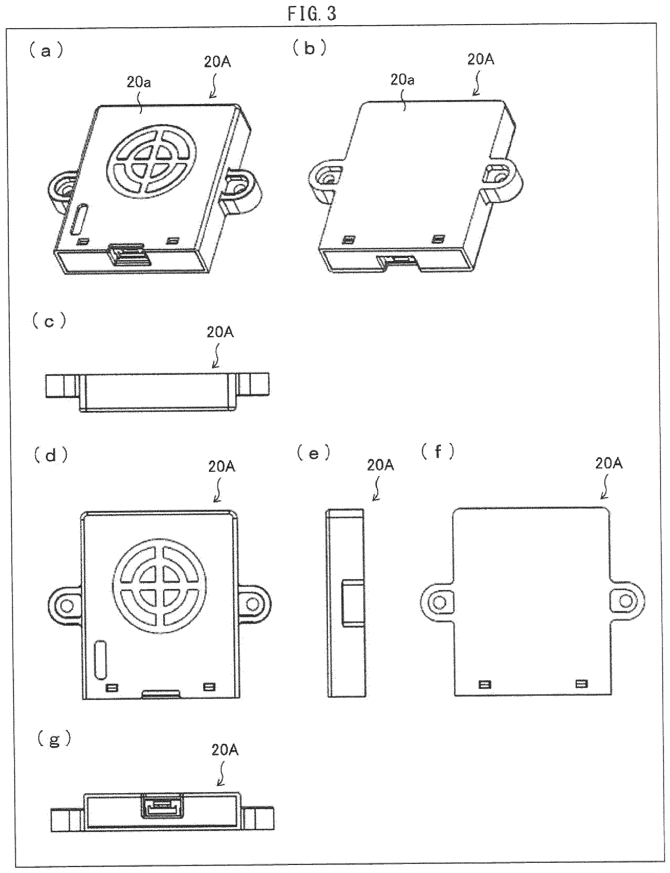

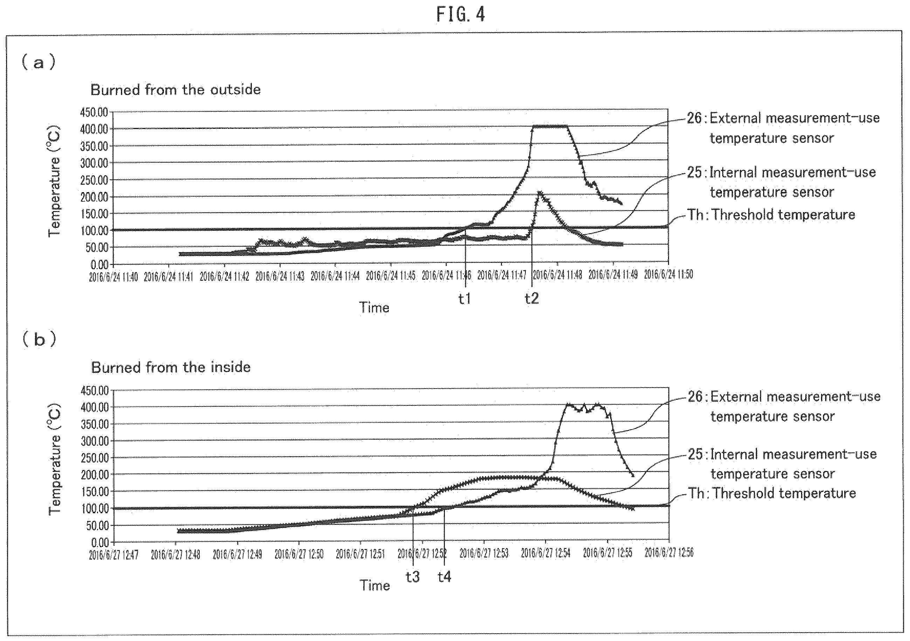

(a) of Fig. 1 is an elevational view illustrating an external configuration of an energy meter in accordance with Embodiment 1 of the present invention, (b) of Fig. 1 is a lateral cross-sectional view illustrating the configuration of the energy meter, and (c) of Fig. 1 is a block diagram illustrating the configuration of a security sensor of the energy meter.

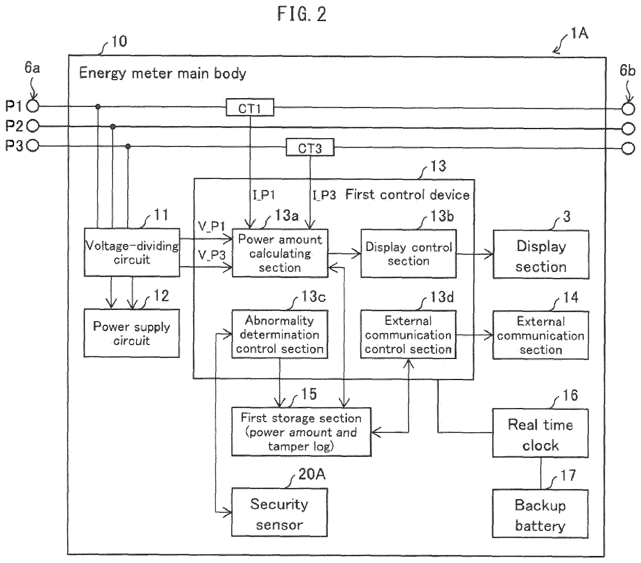

Fig. 2 is a block diagram illustrating an internal configuration of an energy meter main body of the energy meter.
(a) to (g) of Fig. 3 are views illustrating the appearance of the security sensor.
(a) of Fig. 4 is a graph showing temperature changes in internal and external temperatures in a case where the energy meter has been burned from outside the energy meter, and (b) of Fig. 4 is a graph showing temperature changes in internal and external temperatures in a case where fire has broken out from inside the energy meter.
Fig. 5 is a flowchart illustrating a flow of a process in which it is determined which of an internal temperature and an external temperature of the energy meter main body has become equal to or higher than a threshold temperature first.
Fig. 6 is a block diagram illustrating a configuration of a security sensor of the energy meter in accordance with Embodiment 2 of the present invention.
Fig. 7 is a flowchart illustrating a flow of a process in which it is determined, through melting of an internal-use thermal fuse and an external-use thermal fuse, which of an internal temperature and an external temperature of the energy meter main body has become equal to or higher than a threshold temperature first.

### Description of Embodiments

### [Embodiment 1]

The following will describe an embodiment of the present invention with reference to Figs. 1 to 5.

An energy meter in accordance with Embodiment 1, which is a so-called smart meter, is a next-generation energy meter that digitally measures electric power and includes a communication capability inside the meter, unlike the conventional analog induction type energy meter. Specifically, the conventional energy meter, for example, measures the total amount of one-month power consumption by monthly meter reading, whereas the smart meter, for example, transmits the amount of power consumption to an administrator every 30 minutes on a daily basis. Thus, the smart meter has the advantage of eliminating the need for a meter reader to perform a meter reading work.

### [Configuration of energy meter]

(a) of Fig. 1 is an elevational view illustrating an external configuration of the energy meter 1A in accordance with Embodiment 1, and (b) of Fig. 1 is a lateral cross-sectional view illustrating the configuration of the energy meter 1A.

As illustrated in (a) and (b) of Fig. 1, the energy meter 1A in accordance with Embodiment 1 includes a housing 2 which has, for example, a substantially rectangular shape and is made out of, for example, a resin product. The housing 2 has a display section 3, two light emitting diode (LED) lamps 4, and a data extraction terminal 5 provided in an upper part on the front side thereof, and also has a terminal board 6 provided in a lower part on the front side thereof. In the housing 2, a security sensor 20A is fixed to the circuit board 7 and includes an internal measurement-use temperature sensor 25. On a back side of the display section 3, an external measurement-use temperature sensor 26 is provided. The internal measurement-use temperature sensor 25 serves as a first threshold temperature detecting section and a first temperature measuring section. The external measurement-use temperature sensor 26 serves as a second threshold temperature detecting section and a second temperature measuring section.

The display section 3 is realized by a liquid crystal display (LCD) device and is configured to display the amount of power consumption.

One of the LED lamps 4 illuminates during operation of the energy meter 1A to indicate that the energy meter 1A is in operation. Another one of the LED lamps 4 is a lamp which flashes quickly as the amount of power consumption increases to indicate a rate at which the amount of power consumption increases.

In Embodiment 1, the terminal board 6 is provided with, for example, three input terminals 6a and three output terminals 6b. The input terminals 6a are connected to, for example, transmission lines from a utility pole outside a building. On the other hand, the output terminals 6b are connected to wiring lines to the inside of a building. In Embodiment 1, the terminal board 6 is a terminal board in a three-phase AC system. However, the terminal board 6 is not necessarily limited to such a terminal board. Alternatively, the terminal board 6 may be a terminal board in a two-phase AC system.

Fig. 2 is a block diagram illustrating an internal configuration of an energy meter main body 10 of the energy meter 1A. As illustrated in Fig. 2, the energy meter 1A in accordance with Embodiment 1 digitally measures the amount of electric power supplied to, for example, a home or the like through transmission lines P1 to P3 in a three-phase AC system.

As illustrated in Fig. 2, the energy meter main body 10 of the energy meter 1A includes current sensors (current transformers) CT1 and CT3, a voltage-dividing circuit 11, a power supply circuit 12, a first control device 13, a display section 3, an external communication section 14 serving as a transmitting section, a first storage section 15, a real time clock (RTC) 16, a backup battery 17, and a security sensor 20A.

The current sensor CT1 detects a current value I_P1 in the transmission line P1, and the current sensor CT3 detects a current value I_P3 in the transmission line P3.

The voltage-dividing circuit 11 detects a voltage value V_P1 in the transmission line P1 and a voltage value V_P3 in the transmission line P3, and transmits data of the voltage value V_P1 and voltage value V_P3 to a power amount calculating section 13a of the first control device 13 (described later).

The power supply circuit 12 supplies electric power to hardware included in the energy meter 1A.

The display section 3 is a display device which is electrically connected directly to the first control device 13 and is controlled by the first control device 13 to output and display power consumption. The display section 3 is attached to the housing 2 so as to be visible from outside the energy meter 1A. This allows a consumer to view the information displayed on the display section 3.

The external communication section 14 serves as a communication port for communicating with a terminal device at an electric power company through a communication network (not illustrated). The communication network may be a radio communication network (for example, wireless LAN) or may be a wired communication network such as, for example, power line communication (PLC).

The first storage section 15 serves as a storage area for storing information, and employs, for example, an electrically erasable programmable read-only memory (EEPROM) (Registered Trademark) in Embodiment 1. The first storage section 15 stores the amount of power calculated by the power amount calculating section 13a (described later) and a tamper log determined by an abnormality determination control section 13c. The first control device 13 performs reading/writing of information from/to the first storage section 15.

The first control device 13 is constituted by a control circuit board for controlling the hardware in the energy meter 1A, specifically including a processor (for example, a central processing unit (CPU)) for executing a program.

The first control device 13 includes the power amount calculating section 13a, a display control section 13b, the abnormality determination control section 13c which serves as the determining section, and an external communication control section 13d. Although the first control device 13 is constituted by hardware, the power amount calculating section 13a, the display control section 13b, the abnormality determination control section 13c, and the external communication control section 13d, which are included in the first control device 13, are each a functional block representing the software functions executed by the first control device 13.

The power amount calculating section 13a represents a function block for calculating (measuring) the amount of electric power supplied to a house through the transmission lines P1 to P3 (i.e., the power consumption of a power supply target) using detection values from the current sensors CT1 and CT3 and the voltage-dividing circuit 11.

Specifically, the power amount calculating section 13a calculates an instantaneous power value in the transmission line P1 by multiplying the current value IP_1 by the voltage value V_P1 and calculates an instantaneous power value in the transmission line P3 by multiplying the current value I_P3 by the voltage value V__P3. Then, the power amount calculating section 13a calculates a first power consumption for a first prescribed period (for example, a few seconds) by time-integrating the sum of the instantaneous power value in the transmission line P1 and the instantaneous power value in the transmission line P3.

Further, the power amount calculating section 13a calculates a second power consumption for every second prescribed period (15 minutes in Embodiment 1) which is longer than the first prescribed period, and stores the second power consumption in the first storage section 15.

Note that the power amount calculating section 13a does not necessarily calculate the first power consumption for every few seconds or the second power consumption for every 15 minutes. For example, the power amount calculating section 13a may calculate the power consumption for every day or for every month and store the calculated power consumption in the first storage section 15.

The display control section 13b represents a block for controlling the display section 3. The display control section 13b acquires the first power consumption from the power amount calculating section 13a every time the power amount calculating section 13a calculates, for example, the first power consumption, and causes the first power consumption to be displayed on the display section 3.

Further, the display control section 13b may cause any one of the second power consumption for 15 minutes, daily power, and monthly power stored in the first storage section 15 to be displayed on the display section 3 in response to the input of an external command (a command from an operator).

The abnormality determination control section 13c acquires a tamper log (detailed later) generated by the security sensor 20A from the security sensor 20A and stores the tamper log in the first storage section 15. Specifically, every time an internal threshold temperature determining section 32a and an external threshold temperature determining section 32b of a sensor data determining section 32 (described later) in the security sensor 20A determine that respective threshold temperatures Th set in advance have been reached, determination results are transmitted via a determination data transmitting section 31b to the abnormality determination control section 13c. The abnormality determination control section 13c determines which of the internal temperature and the external temperature is indicated by the transmitted results to have reached a corresponding threshold temperature first. Then, in a case where the abnormality determination control section 13c determines that the external temperature reached the threshold temperature before the internal temperature, such a fact which serves as an evidence that a person who performs fraudulent activity burned the energy meter 1A is stored as a tamper log in the first storage section 15.

Every time the power amount calculating section 13a calculates power consumption, the external communication control section 13d controls the external communication section 14 to transmit power amount information indicating power consumption to a terminal device (not illustrated) of the electric power company which is an administrator.

Further, the external communication control section 13d transmits the tamper log having been determined by the abnormality determination control section 13c and stored in the first storage section 15, via the external communication section 14 to the terminal device of the electric power company which is the administrator.

The real time clock (RTC) 16 outputs time information indicating the present time including the year, month, day, hour, minute, and second. Since the real time clock (RTC) 16 is connected to a backup battery 17, the RTC 16 will not stop operating because of a power outage or the like, and constantly outputs the exact time information.

Since the time information provided from the real time clock (RTC) 16 is transmitted to the first control device 13, the first control device 13 recognizes the present time on the basis of the time information provided from the real time clock (RTC) 16. A second control device 30 in the security sensor 20A (described later) also acquires time information from the real time clock (RTC) 16 through the first control device 13 when the security sensor 20A starts; sets a timer (not illustrated) to the present time acquired; and recognizes the present time on the basis of the timer.

(c) of Fig. 1 is a block diagram illustrating the configuration of the security sensor 20A of the energy meter 1A. (a) of Fig. 3 is a perspective view illustrating the security sensor 20A of the energy meter 1A when viewed from a front side of the security sensor 20A, and (b) of Fig. 3 is a perspective view illustrating the security sensor 20 when viewed from a back side of the security sensor 20A. (c) to (g) of Fig. 3 are basic five views illustrating the appearance of the security sensor 20. Specifically, (c) of Fig. 3 is a plan view of the security sensor 20A, (d) of Fig. 3 is an elevational view of the security sensor 20A, (e) of Fig. 3 is a right side view of the security sensor 20A, (f) of Fig. 3 is a back side view of the security sensor 20A, and (g) of Fig. 3 is a bottom view of the security sensor 20A.

The security sensor 20A is a detection device installed on the circuit board 7 inside the housing 2, as illustrated in (a) and (b) of Fig. 1, and can be removed from the energy meter 1A. The security sensor 20A is configured to detect fraudulent activity carried out for electricity theft on the energy meter 1A.

As illustrated in (c) of Fig. 1, the security sensor 20A includes a radio wave sensor 21, an electrostatic sensor 22, a magnetic-field sensor 23, an acceleration sensor 24, an internal measurement-use temperature sensor 25, an external measurement-use temperature sensor 26, a second control device 30, and a second storage section 27. In this way, the energy meter 1A in Embodiment 1 is provided with various kinds of sensors for preventing electricity theft through a variety of fraudulent activities carried out on the energy meter 1A. However, in an aspect of the present invention, the security sensor 20A need only include at least the internal measurement-use temperature sensor 25 and the external measurement-use temperature sensor 26.

The security sensor 20A has a resin package 20a illustrated in (a) and (b) of Fig. 3. In the package 20a, the following are contained: the radio wave sensor 21, the electrostatic sensor (ESD Surge sensor) 22, the magnetic-field sensor 23, the acceleration sensor 24, and the internal measurement-use temperature sensor 25. The external measurement-use temperature sensor 26 illustrated in (c) of Fig. 1 is not included in the package 20a.

The radio wave sensor 21 outputs a sensor value AD1 correlated with the amount of radio waves in a frequency band that would cause electromagnetic interference (EMI) in an electronic device. Specifically, when radio waves are emitted to render the processor for measuring power consumption (first control device 13 in Embodiment 1) inoperable, the sensor value AD1 outputted from the radio wave sensor 21 increases. Consequently, by detecting electromagnetic interference with use of the radio wave sensor 21, it is possible to prevent electricity theft committed through electromagnetic interference. When the first control device 13 is rendered inoperable by the emission of radio waves, the first control device 13 cannot measure power consumption, thereby allowing electricity theft to take place.

The electrostatic sensor (ESD surge sensor) 22 outputs a sensor value AD2 corresponding to an increased amount of charge when surge takes place in the energy meter 1A. Specifically, when an electrostatic discharge is induced to render the processor for measuring power consumption (first control device 13 in Embodiment 1) inoperable, surge takes place in the energy meter 1A, thus causing the sensor value AD2 to increase. Consequently, by detecting electrostatic discharge induced for the purpose of electricity theft with use of the electrostatic sensor 22, it is possible to prevent electricity theft committed through electrostatic discharge. When the first control device 13 is rendered inoperable by the electrostatic discharge, the first control device 13 cannot measure power consumption, thereby allowing electricity theft to take place.

The magnetic-field sensor 23 outputs a sensor value AD3 correlated with the intensity of a magnetic field. Specifically, when the energy meter 1A is exposed to a magnetic field for the purpose of causing the current sensors CT1 and CT3 to malfunction, the sensor value AD3 outputted from the magnetic-field sensor 23 increases. Consequently, by detecting exposure to a magnetic field with use of the magnetic-field sensor 23, it is possible to prevent electricity theft committed via exposure to a magnetic field. When the current sensors CT1 and CT3 malfunction due to exposure to a magnetic field, the current amount is not outputted normally, and thus the power amount calculating section 13a cannot measure the power amount, thereby allowing electricity theft to take place.

The acceleration sensor 24 measures a rate at which an object moves, and can detect inclination (gravity), motion, vibration and impact of an object. Specifically, when a fraudulent activity such as an impact given to the energy meter 1A with, for example, a drill is committed for the purpose of breaking the housing 2 of the energy meter 1A, the sensor value AD4 outputted from the acceleration sensor 24 increases. Consequently, by detecting breakage of the energy meter main body 10 committed for the purpose of electricity theft with use of the acceleration sensor 24, it is possible to prevent electricity theft committed via breakage of the energy meter main body 10. When the energy meter main body 10 is broken, the power amount cannot be measured. This allows electricity theft to take place. In addition, even in a case where, for example, a thermocouple (described later) of the external measurement-use temperature sensor 26 is extracted by a fraudster, vibration occurs. This allows the acceleration sensor 24 to detect that the external measurement-use temperature sensor 26 has been extracted.

The internal measurement-use temperature sensor 25 and the external measurement-use temperature sensor 26 measure temperatures corresponding to an internal temperature and an external temperature, respectively, of the energy meter main body 10, and each include, for example, a thermocouple or a resistance temperature detector. As described earlier, the internal measurement-use temperature sensor 25 in accordance with Embodiment 1 is housed inside the package 20a of the security sensor 20A, and measures internal temperature of the housing 2, internal temperature of the security sensor 20A in particular. Note that the internal measurement-use temperature sensor 25 does not necessarily need to be housed inside the package 20a of the security sensor 20A. Alternatively, for example, the internal measurement-use temperature sensor 25 may be, for example, exposed and fixed on the circuit board 7, rather than being housed inside the package 20a, so that a temperature of the circuit board 7 or a temperature in the vicinity of the circuit board 7 is measured. The internal measurement-use temperature sensor 25 is provided at the first location which is located inside the housing 2. There is a high possibility that the origin of a fire from inside is the power supply circuit 12 on the circuit board 7. Thus, it is preferable to provide the internal measurement-use temperature sensor 25 in the vicinity of the power supply circuit 12.

As illustrated in (b) of Fig. 1, the external measurement-use temperature sensor 26 is provided not in the security sensor 20A but at the second location which is located inside the housing 2. The second location is located closer to the housing 2 than is the first location. According to Embodiment 1, the external measurement-use temperature sensor 26 is provided, for example, below the display section 3 so as to be adjacent to an inner side surface of the housing 2. Therefore, the external measurement-use temperature sensor 26 detects a temperature which is closer to an external temperature of the housing 2 than is a temperature detected by the internal measurement-use temperature sensor 25. The external measurement-use temperature sensor 26 can measure a temperature of the housing 2, or can measure a temperature in the vicinity of the housing 2. The external measurement-use temperature sensor 26 can be provided so as to be adjacent to an inner side surface of the display section 3. The external measurement-use temperature sensor 26 and the housing 2 can provided apart from each other. For example, the thermocouple of the external measurement-use temperature sensor 26 in accordance with Embodiment 1 is provided in a small gap between the display section 3 and the housing 2. This allows the temperature of the housing 2 of the energy meter main body 10 to be measured. The main body of the external measurement-use temperature sensor 26 can be located inside the housing 2, provided that the temperature to be measured by the external measurement-use temperature sensor 26 is a temperature of the housing 2 or a temperature in the vicinity of the housing 2. The "temperature of the housing 2 or the temperature in the vicinity of the housing 2" can be not only a temperature at a front side of the housing 2 but also temperatures at an upper surface, a side surface, or a lower surface of the housing 2.

The working effects of the internal measurement-use temperature sensor 25, the external measurement-use temperature sensor 26, the second control device 30, and the second storage section 27 will be described in detail below.

### [Configuration for preventing fraudulent activity of burning energy meter for the purpose of electricity theft]

Conventionally, a fraudulent activity of willfully burning an energy meter to destroy the display section on which an accumulated power consumption is displayed and accumulated power consumption data stored in the energy meter is committed for the purpose of electricity theft. In this case, when an administrator of, for example, an electric power company which administers the energy meter, files a claim for the damage against the wrongdoer, the wrongdoer may evade compensation for the damage by arguing that a fire broke out from inside the energy meter due to current leakage or the like.

Thus, against the fraudulent activity of willfully burning an energy meter, it is important to identify that the energy meter has been burned from outside the energy meter.

Here, respective temperature changes in internal temperature and external temperature of an energy meter in the case where the energy meter has been burned from outside the energy meter and in the case where fire has broken out from inside the energy meter will be described on the basis of experimental results shown in (a) and (b) of Fig. 4. (a) of Fig. 4 is a graph showing temperature changes in internal and external temperatures in the case where the energy meter has been burned from outside the energy meter. (b) of Fig. 4 is a graph showing temperature changes in internal and external temperatures in the case where a fire has broken out from inside the energy meter. In (a) and (b) of Fig. 4, a vertical axis represents a temperature (°C), and a horizontal axis represents an elapsed time (year, month, day, hour, minute). In (a) of Fig. 4, fire is set from outside at 11:42:30.

As shown in (a) of Fig. 4, in a case where the energy meter 1A has been burned from outside, the external temperature of the energy meter main body 10 rises earlier than the internal temperature of the energy meter main body 10, and after that, the internal temperature sharply rises at a given point in time. This is considered to occur because the housing 2 of the energy meter main body 10 is burned out at the point in time when the circuit board 7 and other members provided inside the energy meter main body 10 catch fire, and air is sufficiently distributed throughout the inside so that the inside of the energy meter main body 10 is burned within a short period in time.

Specifically, the external temperature detected by the external measurement-use temperature sensor 26 is at a threshold temperature Th which was set to time t1 (=11:46:20) in advance. Meanwhile, the internal temperature detected by the internal measurement-use temperature sensor 25 is at a threshold temperature Th which was set to time t2 (=11:47:30) in advance. In Embodiment 1, the threshold temperature Th is, for example, 100°C. However, the threshold temperature Th is not necessarily 100°C and may be other temperature. The threshold of the external temperature and the threshold of the internal temperature can be different. For example, it is possible that (i) the threshold of the external temperature is 150°C and (ii) the threshold of the internal temperature is 100°C.

It is therefore understood that in a case where fire has been set to the energy meter 1A from outside, the external temperature of the energy meter 1A reaches the threshold temperature Th before does the internal temperature.

Meanwhile, as illustrated in (b) of Fig. 4, in a case where fire has broken out from inside the energy meter 1A, the internal temperature is less likely to rise sharply since the energy meter main body 10 is sealed and the inside of the energy meter 1A is deficient in oxygen. At a stage where the housing 2 of the energy meter main body 10 catches fire, the external temperature rises gradually. Finally, at a stage where a hole is made to the housing 2, air (oxygen) is supplied through the hole. This causes the external temperature of the energy meter 1A to rise sharply.

Specifically, the internal temperature detected by the internal measurement-use temperature sensor 25 is at a threshold temperature Th which was set to time t3 (=12:51:50) in advance. Meanwhile, the external temperature detected by the external measurement-use temperature sensor 26 is at a threshold temperature Th which was set to time t4 (=12:52:25) in advance. Note that the threshold temperature Th is, for example, 100°C which is a threshold temperature Th in a case where fire is set to the energy meter 1A from outside.

It is therefore understood that in a case where fire breaks out from inside the energy meter 1A, the internal temperature of the energy meter 1A reaches the threshold temperature Th before does the external temperature.

Consequently, in a case where fire has been set to the energy meter 1A from outside, the external temperature of the energy meter 1A becomes equal to or higher than the threshold temperature Th first, and then the internal temperature of the energy meter 1A becomes equal to or higher than the threshold temperature Th. On the other hand, in a case where the energy meter has burned because fire has broken out from inside due to current leakage or the like, the internal temperature of the energy meter 1A becomes equal to or higher than the threshold temperature Th first, and then the external temperature of the energy meter 1A becomes equal to or higher than the threshold temperature Th.

Therefore, in a case where it can be demonstrated that the external temperature of the energy meter 1A became equal to or higher than the threshold temperature Th before the internal temperature, it is then possible to prove that the fraudulent activity of willfully burning the energy meter 1A was committed.

Hence, as illustrated in (c) of Fig. 1, the energy meter 1A in accordance with Embodiment 1 includes: an internal threshold temperature detecting section configured to detect that the internal temperature of the energy meter main body 10 has become equal to or higher than the threshold temperature Th which was set in advance; an external threshold temperature detecting section configured to detect that the external temperature in the vicinity of the energy meter main body 10 has become equal to or higher than the threshold temperature Th; the abnormality determination control section 13c which serves as a determining section and which is configured to determine, based on a result of detection by the internal threshold temperature detecting section and a result of detection by the external threshold temperature detecting section, which one of the internal temperature and the external temperature of the energy meter main body 10 became the threshold temperature Th first; and the external communication section 14 which serves as a transmitting section and which is configured to transmit, to an outside entity, a result of determination by the abnormality determination control section 13c.

Specifically, the second control device 30, which is configured to perform control so that the above operations are performed, includes a data communication section 31 and the sensor data determining section 32. The second control device 30 is constituted by a control circuit board separated from the first control device 13, including a processor (for example, a CPU) for controlling the hardware in the security sensor 20A.

The data communication section 31 includes (i) a sensor data acquiring section 31a and (ii) a determination data transmitting section 31b which serves as a first threshold temperature reaching transmitting section and a second threshold temperature reaching transmitting section. The sensor data acquiring section 31a is configured to acquire (i) data AD5, transmitted from the internal measurement-use temperature sensor 25, on the internal temperature of the energy meter main body 10, (ii) data AD6, transmitted from the external measurement-use temperature sensor 26, of the external temperature of the energy meter main body 10, or (iii) sensor values AD1 to AD4 transmitted from the other sensors 21 to 24, respectively. In a case where the sensor data determining section 32 determines that the external temperature and the internal temperature of the energy meter main body 10 have become equal to or higher than the threshold temperature Th, the determination data transmitting section 31b transmits the determination results to the abnormality determination control section 13c.

Next, the sensor data determining section 32 includes the internal threshold temperature determining section 32a and the external threshold temperature determining section 32b. The internal threshold temperature determining section 32a compares the data AD5, transmitted from the internal measurement-use temperature sensor 25, on the internal temperature of the energy meter main body 10 to the preset threshold temperature Th. Then, when the data AD5 indicates that the internal temperature of the energy meter main body 10 has become equal to or higher than the threshold temperature Th, the determination result is immediately transmitted to the determination data transmitting section 31b. The external threshold temperature determining section 32b compares the data AD6, transmitted from the external measurement-use temperature sensor 26, of the external temperature of the energy meter main body 10 to the preset threshold temperature Th. Then, when the data AD6 indicates that the external temperature of the energy meter main body 10 has become equal to or higher than the threshold temperature Th, the determination result is immediately transmitted to the determination data transmitting section 31b.

Note that the threshold temperature Th can be changed via the external communication section 14 by an entry through a terminal device (not illustrated) of the administrator.

Here, the sensor data determining section 32 is connected to the second storage section 27. The second storage section 27 stores, as a detection log, a status of the determinations performed by the internal threshold temperature determining section 32a and the external threshold temperature determining section 32b in the sensor data determining section 32.

The second storage section 27 includes a storage area for storing information and employs a flash memory in Embodiment 1. The second control device 30 performs reading/writing of information from/to the second storage section 27.

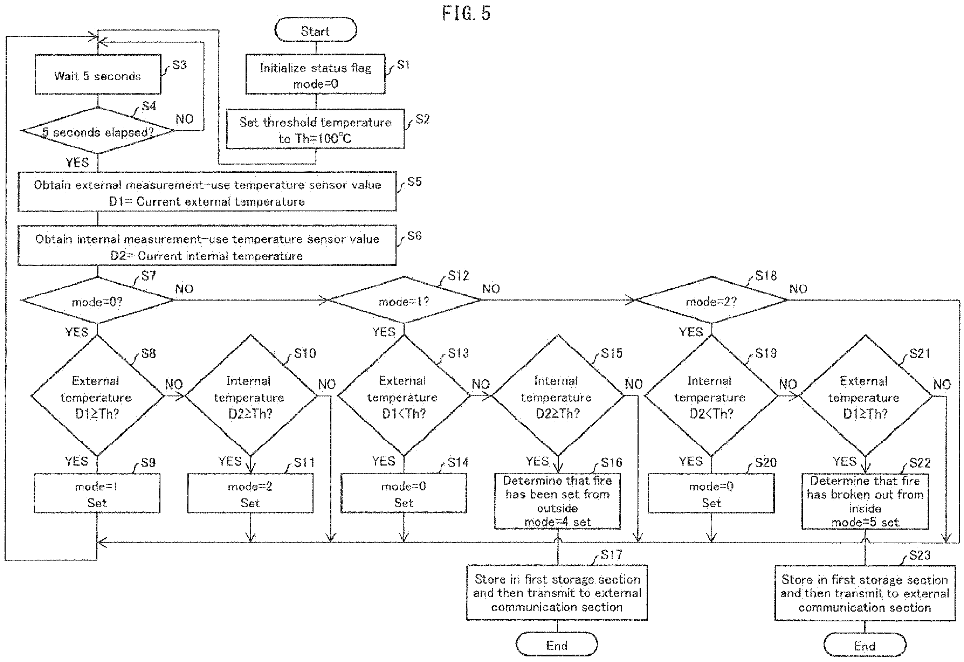

Fig. 5 is a flowchart illustrating a flow of a process in which it is determined which of an internal temperature and an external temperature of the energy meter main body 10 has become equal to or higher than a threshold temperature Th first.

As illustrated in Fig. 5, first, a status flag is initialized (S1). Specifically, "mode=0" is set as an initial value. Next, the threshold temperature Th is set (S2). According to Embodiment 1, the threshold temperature Th is set to, for example, 100°C. Note that the threshold temperature Th is preferably set to a temperature which is, for example, (i) not lower than 80°C above which the internal temperature becomes high within a short period in time as illustrated in (a) of Fig. 4 and (ii) not higher than 170°C that is equal to or below a maximum temperature of the internal temperature illustrated in (b) of Fig. 4. In addition, the threshold temperature Th needs to be higher than an ordinary living temperature. If the threshold temperature Th is set to an excessively high temperature, then there is a risk that the circuit board 7 or the like may be burned to the point of breakage, so as not to be able to transmit communication data. In Embodiment 1, therefore, the threshold temperature Th is, for example, 100°C.

Next, the process waits (on standby) 5 seconds (S3), and then determines whether or not 5 seconds has elapsed (S4). In a case where it is determined in the step S4 that 5 seconds has not elapsed, the process returns to the step S3. Although the standby time is, for example, 5 seconds in Embodiment 1, the standby time is not necessarily limited to 5 seconds, and can be set to another value. Note, however, that as illustrated in (a) and (b) of Fig. 4, the external temperature and the internal temperature each change rapidly after the energy meter main body 10 starts burning. In a case where, for example, fire has broken out from inside as illustrated in (b) of Fig. 4, the following is true: t4 - t3 = 35 sec. Therefore, the standby time is preferably 15 seconds or less, more preferably 10 seconds or less, and most preferably 5 seconds or less.

In a case where it is determined in the step S4 that 5 seconds has elapsed, a current external temperature D1 is obtained as data AD6 on the external temperature measured by the external measurement-use temperature sensor 26 (S5), and a current internal temperature D2 is obtained as data AD5 on the internal temperature measured by the internal measurement-use temperature sensor 25 (S6).

Next, it is determined whether or not the "mode=0" is true (S7).

In a case where it is determined in the step S7 that "mode=0" is true, it is then determined whether or not "external temperature D1 ≥ threshold temperature Th" is true (S8), In a case where it is determined in the step S8 that "external temperature D1 ≥ threshold temperature Th" is true, "mode=1" is set (S9), and the process returns to the step S3. Meanwhile, in a case where it is determined in the step S8 that "external temperature D1 ≥ threshold temperature Th" is false, it is then determined whether or not "internal temperature D2 ≥ threshold temperature Th" is true (S10). In a case where it is determined in the step S10 that "internal temperature D2 ≥ threshold temperature Th" is true, "mode=2" is set (S11), and the process returns to the step S3. Meanwhile, in a case where it is determined in the step S10 that "internal temperature D2 ≥ threshold temperature Th" is false, the process directly returns to the step S3.

Meanwhile, in a case where it is determined in the step S7 that "mode=0" is false, it is then determined whether or not "mode=1" is true (S12).

In a case where it is determined in the step S12 that "mode=1" is true, it is then determined whether or not "external temperature D1 < threshold temperature Th" is true (S13). In a case where it is determined in the step S13 that "external temperature D1 < threshold temperature Th" is true, "mode=0" is set (S14), and the process returns to the step S3. Meanwhile, in a case where it is determined in the step S13 that "external temperature D1 < threshold temperature Th" is false, it is then determined whether or not "internal temperature D2 ≥ threshold temperature Th" is true (S15). In a case where it is determined in the step S15 that "internal temperature D2 ≥ threshold temperature Th" is true, (i) it is then determined that fire has been set from outside and (ii) "mode=4" is set (S16). Then, the result of the determination is stored as a tamper log in the first storage section 15, and then the result of the determination is transmitted to the external communication section 14 (S17). The external communication section 14 transmits the result of the determination to a terminal device provided outside the energy meter. Note that it is the abnormality determination control section 13c which determines that (i) the external temperature D1 has become equal to or higher than a corresponding threshold temperature Th before the internal temperature D2 and (ii) fire has been set from outside.

With the process above, an administrator can recognize, with use of an in-house terminal device (not illustrated), that fire has been set to the energy meter 1A from outside. Meanwhile, in a case where it is determined in the step S15 that "internal temperature D2 ≥ threshold temperature Th" is false, the process directly returns to the step S3.

Meanwhile, in a case where it is determined in the step S12 that "mode=1" is false, it is then determined whether or not "mode=2" is true (S18).

In a case where it is determined in the step S18 that "mode=2" is true, it is then determined whether or not "internal temperature D2 < threshold temperature Th" is true (S19). In a case where it is determined in the step S19 that "internal temperature D2 < threshold temperature Th" is true, "modc=0" is set (S14), and the process returns to the step S3. Meanwhile, in a case where it is determined in the step S19 that "internal temperature D2 < threshold temperature Th" is false, it is then determined whether or not "external temperature D1 ≥ threshold temperature Th" is true (S21). In a case where it is determined in the step S21 that "external temperature D1 ≥ threshold temperature Th" is true, (i) it is then determined that fire has broken out from inside and (ii) "mode=5" is set (S22). Then, the result of the determination is stored in the first storage section 15, and is then transmitted to the external communication section 14 (S23). The external communication section 14 transmits the result of the determination to a terminal device provided outside the energy meter. Note that it is the abnormality determination control section 13c which determines that (i) the internal temperature D2 has become equal to or higher than a corresponding threshold temperature Th before the external temperature D1 and (ii) fire has broken out from inside.

With the process above, the administrator can recognize, with use of an in-house terminal device (not illustrated), that fire has broken out from inside the energy meter 1A due to current leakage or the like. In a case where it is determined in the step S21 that "external temperature D1 ≥ threshold temperature Th" is false, the process directly returns to the step S3. In a case where it is determined in the step S18 that "mode=2" is false, the process directly returns to the step S3.

The energy meter 1A of Embodiment 1 thus accumulates power consumption. The following are provided: a first threshold temperature detecting section configured to detect that a temperature of a first location inside the energy meter main body 10 has become equal to or higher than threshold temperature Th which is a first threshold temperature and which was set in advance; a second threshold temperature detecting section configured to detect that a temperature of a second location, which is located closer to the housing 2 of the energy meter main body 10 than is the first location, has become equal to or higher than a threshold temperature Th which is a second threshold temperature; the abnormality determination control section 13c which serves as a determining section and determines, based on a result of detection by the first threshold temperature detecting section and a result of detection by the second threshold temperature detecting section, which one of the following (i) and (ii) occurred before the other: (i) the temperature of the first location of the energy meter main body 10 became equal to or higher than the threshold temperature Th and (ii) the temperature of the second location became equal to or higher than the threshold temperature Th; and the external communication section 14 which serves as a transmitting section and which transmits, to an outside entity, the result of determination by the abnormality determination control section 13c. According to Embodiment 1, the external communication section 14 can transmit a result of the determination by the abnormality determination control section 13c to an outside entity, examples of the result encompassing (i) the fact that the temperature of the second location of the energy meter main body 10 became equal to or higher than the threshold temperature Th before the temperature of the first location of the energy meter main body 10 became equal to or higher than the threshold temperature Th and(ii) the fact that the temperature of the first location of the energy meter main body 10 became equal to or higher than the threshold temperature Th before the temperature of the second location of the energy meter main body 10 became equal to or higher than the threshold temperature Th. In addition, the second threshold temperature and the first threshold temperature can be identical as in Embodiment 1 or can be different.

Consequently, even if data on, for example, power consumption charge stored inside the energy meter main body 10 is deleted by the burning of the energy meter 1A, an administrator of the energy meter 1A obtains, through communication before the energy meter main body 10 is burned out, the result of the determination as to which one of the following (i) and (ii) occurred before the other: (i) the temperature of the first location of the energy meter main body 10 became equal to or higher than the threshold temperature Th and (ii) the temperature of the second location became equal to or higher than the threshold temperature Th.

Note that in a case where the energy meter 1A is not completely burned out and where data, such as the power consumption charge, stored inside the energy meter main body 10 is retained, it is possible to extract the data.

Therefore, it is possible to provide an energy meter 1A which (i) determines whether the fire has broken out from inside the energy meter 1A or the fire has been set to the energy meter 1A from outside and then (ii) retains the results of the determination.

Note that the administrator of the energy meter 1A can file a claim for damages against a fraudster on the evidence of the result of the determination.

In addition, the energy meter 1A in accordance with Embodiment 1 is configured so that (i) the first threshold temperature detecting section includes: the internal measurement-use temperature sensor 25 which serves as a first temperature measuring section and which periodically measures the temperature of the first location of the energy meter main body 10; the internal threshold temperature determining section 32a which serves as a first threshold temperature determining section and which determines whether or not the temperature of the first location has become equal to or higher than the threshold temperature Th serving as a first threshold temperature; the determination data transmitting section 31b which serves as a first threshold temperature reaching transmitting section and which transmits, to the abnormality determination control section 13c serving as a determining section, information that the temperature of the first location has become equal to or higher than the first threshold temperature and (ii) the second threshold temperature detecting section includes: the external measurement-use temperature sensor 26 which serves as a second temperature measuring section and which periodically measures the temperature of the second location of the energy meter main body 10; the external threshold temperature determining section 32b which serves as a second threshold temperature determining section and which determines whether or not the temperature of the second location has become equal to or higher than the threshold temperature Th serving as a second threshold temperature; the determination data transmitting section 31b which serves as a second threshold temperature reaching transmitting section and which transmits, to the abnormality determination control section 13c, information that the temperature of the second location has become equal to or higher than the threshold temperature Th.

Therefore, in a case where a quantitative internal measurement-use temperature sensor 25 and a quantitative external measurement-use temperature sensor 26 are used, it is possible that, specifically, the abnormality determination control section 13c transmits a result of the determination to an outside entity via the external communication section 14, the result determining which of the internal temperature and the external temperature became equal to or higher than the threshold temperature Th first.

In addition, the energy meter 1A in accordance with Embodiment 1 is configured so that (i) the determination data transmitting section 31b which serves as a first threshold temperature reaching transmitting section transmits, to the abnormality determination control section 13c serving as a determining section, information including: the measured temperature of the first location; and detection time at which the temperature of the first location was detected, (ii) the information thus transmitted to the abnormality determination control section 13c is then transmitted to an outside terminal device by the external communication section 14 serving as a transmitting section, (iii) the determination data transmitting section 31b which serves as a second threshold temperature reaching transmitting section transmits, to the abnormality determination control section 13c, information including: the measured temperature of the second location; and the detection time at which the temperature of the second location was detected, and the information thus transmitted to the abnormality determination control section 13c is then transmitted to the outside terminal device by the external communication section 14.

Therefore, information to be transmitted includes both (a) the result of determining which one of the following (i) and (ii) occurred before the other one: (i) the temperature of the first location of the energy meter main body 10 became equal to or higher than the threshold temperature Th and (ii) the temperature of the second location became equal to or higher than the second threshold temperature and (b) detection times at which respective temperatures of the first location and of the second location were detected. This allows an administrator to obtain specific information on changes in the temperature of the first location and in the temperature of the second location.

Therefore, the energy meter 1A in accordance with Embodiment 1 is configured so that (i) the first threshold temperature detecting section detects, at intervals of 15 seconds or less, whether or not the temperature of the first location has become equal to or higher than the threshold temperature Th serving as a first threshold temperature and (ii) the second threshold temperature detecting section detects, at intervals of 15 seconds or less, whether or not the temperature of the second location has become equal to or higher than the threshold temperature Th serving as a second threshold temperature.

In a case where an energy meter 1A is burned, a rate of temperature rise per unit time is high. Therefore, unless the first threshold temperature detecting section and the second threshold temperature detecting section frequently detect temperatures, it is not possible to recognize which one of the following (i) and (ii) occurred before the other: (i) the temperature of the first location of the energy meter main body 10 became equal to or higher than the threshold temperature Th and (ii) the temperature of the second location became equal to or higher than the threshold temperature Th.

Therefore, (i) the first threshold temperature detecting section detects, at intervals of 15 seconds or less, whether or not the temperature of the first location has become equal to or higher than the first threshold temperature and (ii) the second threshold temperature detecting section detects, at intervals of 15 seconds or less, whether or not the temperature of the second location has become equal to or higher than the second threshold temperature.

This makes it possible to reliably determine which one of the following (i) and (ii) occurred before the other: (i) the temperature of the first location of the energy meter main body 10 became equal to or higher than the threshold temperature Th and (ii) the temperature of the second location became equal to or higher than the threshold temperature Th.

An energy meter fire outbreak location identification method in accordance with Embodiment 1 is a method of identifying whether a fire outbreak location of an energy meter in which power consumption is accumulated is (i) a first location inside an energy meter main body 10 or (ii) a second location located closer to a housing of the energy meter main body 10 than is the first location, including the steps of: (a) detecting that a temperature of the first location of the energy meter main body 10 has become equal to or higher than a corresponding threshold temperature Th which serves as a first threshold temperature and which was set in advance; (b) detecting that a temperature of the second location of the energy meter main body 10 has become equal to or higher than a corresponding threshold temperature Th which serves as a second threshold temperature and which was set in advance; (c) determining which one of the following (i) and (ii) occurred before the other: (i) the temperature of the first location became equal to or higher than the corresponding threshold temperature Th and (ii) the temperature of the second location became equal to or higher than the corresponding threshold temperature Th; and (d) transmitting, to an outside entity, a result of the step (c).

Therefore, it is possible to provide an energy meter and energy meter fire outbreak location identification method, each of which can (i) determine whether the fire has broken out from inside the energy meter 1A or the fire has been set to the energy meter 1A from outside and then (ii) retain the results of the determination.

### [Embodiment 2]

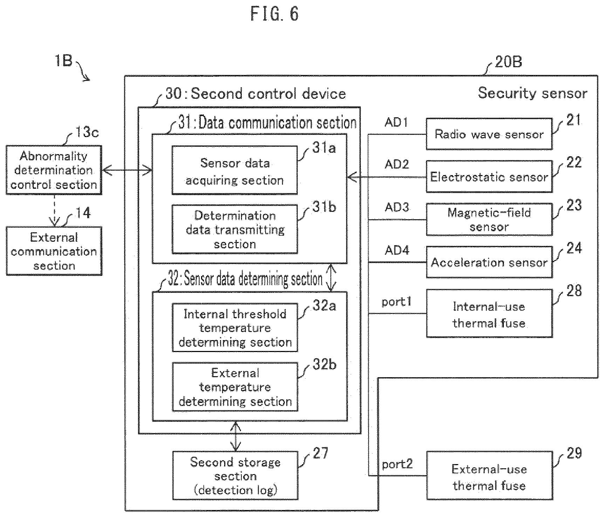

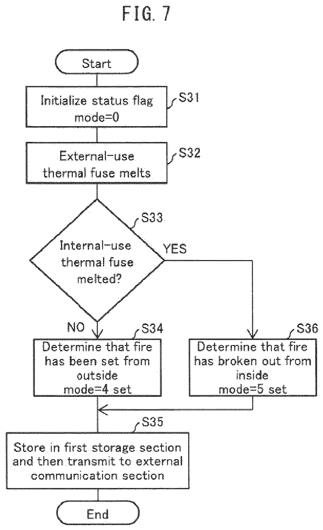

The following description will discuss another embodiment of the present invention with reference to Figs. 6 and 7. Features of Embodiment 2 other than those described in Embodiment 2 are identical to those of Embodiment 1. For convenience, members having functions identical to those illustrated in the drawings of Embodiment 1 are given identical reference signs, and their descriptions are omitted.

According to Embodiment 1, (i) the first threshold temperature detecting section includes the internal measurement-use temperature sensor 25 as a first temperature measuring section, (ii) the second threshold temperature detecting section includes the external measurement-use temperature sensor 26 as a second temperature measuring section, and (iii) the energy meter 1A thus measures temperatures quantitatively.

Meanwhile, an energy meter 1B at which Embodiment 2 differs in that (i) the first threshold temperature detecting section includes an internal-use thermal fuse which melts when reaching a temperature equal to or higher than a threshold temperature Th as a first threshold temperature, (ii) the second threshold temperature detecting section includes an external-use thermal fuse which melts when reaching a temperature equal to or higher than a threshold temperature Th as a second threshold temperature, and (iii) the energy meter 1B thus measures temperatures qualitatively.

Fig. 6 is a block diagram illustrating a configuration of a security sensor 20B of the energy meter 1B in accordance with Embodiment 2.

As illustrated in Fig. 6, the security sensor 20B of the energy meter 1B in accordance with Embodiment 2 differs in that the energy meter 1B is provided with (i) an internal-use thermal fuse 28 instead of the internal measurement-use temperature sensor 25 included in the security sensor 20A of the energy meter 1A in accordance with Embodiment 1 and (ii) an external-use thermal fuse 29 instead of the external measurement-use temperature sensor 26 included in the security sensor 20A of the energy meter 1A in accordance with Embodiment 1.

The internal-use thermal fuse 28 and the external-use thermal fuse 29 are each constituted by a circuit including a fuse which melts at a threshold temperature Th set in advance. For example, an electric current (not illustrated) flows through the internal-use thermal fuse 28 and the external-use thermal fuse 29. When reaching a temperature equal to or higher than a corresponding threshold temperature Th, the internal-use thermal fuse 28 and the external-use thermal fuse 29 each melt, so that the electric current becomes blocked. This makes it possible to detect that the internal-use thermal fuse 28 or the external-use thermal fuse 29 has melted. Note that there can be a difference between (i) a threshold temperature Th at which the fuse included in the internal-use thermal fuse 28 melts and (ii) a threshold temperature Th at which the fuse included in the external-use thermal fuse 29 melts.

Whether or not the internal-use thermal fuse 28 has melted and whether or not the external-use thermal fuse 29 has melted (i.e. whether or not an electric current which was flowing is blocked) can be determined by an internal threshold temperature determining section 32a and an external threshold temperature determining section 32b, respectively, of a sensor data determining section 32.

The fact that the internal-use thermal fuse 28 and the external-use thermal fuse 29 have reached a temperature equal to or higher than a threshold temperature Th so as to melt, which fact has been determined by the internal threshold temperature determining section 32a and the external threshold temperature determining section 32b, respectively, is stored as a detection log in a second storage section 27 and is transmitted to an abnormality determination control section 13c via a determination data transmitting section 31b of a data communication section 31. Then, the abnormality determination control section 13c determines which of the internal-use thermal fuse 28 and the external-use thermal fuse 29 melted first, and then stores, in a first storage section 15, the fact of which of the internal-use thermal fuse 28 and the external-use thermal fuse 29 melted first. Then, the data thus stored is transmitted to a terminal device of an administrator via an external communication control section 13d and an external communication section 14. Therefore, in a case where the external-use thermal fuse 29 melted first, the administrator can recognize, with use of an in-house terminal device (not illustrated), that fire has been set to the energy meter IB.

Fig. 7 is a flowchart illustrating a flow of a process in which it is determined, through melting of the internal-use thermal fuse 28 and the external-use thermal fuse 29, which of an internal temperature and an external temperature of the energy meter main body 10 has become equal to or higher than a threshold temperature Th first.

As illustrated in Fig. 7, first, a status flag is initialized (S31). Specifically, "mode=0" is set as an initial value.

Assume that the external-use thermal fuse 29 melted during standby in this state (S32). In this case, it is immediately determined whether or not the internal-use thermal fuse 28 has melted (S33).

In a case where it is determined in the step S33 that the internal-use thermal fuse 28 has not melted, (i) it is determined that fire has been set from outside and (ii) "mode=4" is set (S34). Then, the result of the determination is stored as a tamper log in the first storage section 15, and then the result of the determination is transmitted to the external communication section 14 (S35). The external communication section 14 transmits the result of the determination to a terminal device provided outside the energy meter. Note that it is the abnormality determination control section 13c which determines that (i) the external-use thermal fuse 29 has reached a temperature equal to or higher than a corresponding threshold temperature Th so as to melt before the internal-use thermal fuse 28 and (ii) fire has been set from outside.

With the process above, an administrator can recognize, with use of an in-house terminal device (not illustrated), that fire has been set to the energy meter 1B from outside.

In a case where it is determined in the step S33 that the internal-use thermal fuse 28 has melted, (i) it is determined that fire has broken out from inside and (ii) "mode=5" is set (S36). Then, the result of the determination is stored in the first storage section 15, and is then transmitted to the external communication section 14 (S35). The external communication section 14 transmits the result of the determination to a terminal device provided outside the energy meter. Note that it is the abnormality determination control section 13c which determines that (i) the internal-use thermal fuse 28 has reached a temperature equal to or higher than a corresponding threshold temperature Th so as to melt before the external-use thermal fuse 29 and (ii) fire has broken out from inside.

With the process above, the administrator can recognize, with use of an in-house terminal device (not illustrated), that fire has broken out from inside the energy meter 1B due to current leakage or the like.

Note that when the internal-use thermal fuse 28 melts, the energy meter 1B preferably transmits, to a terminal device provided outside, the result of determining that the internal-use thermal fuse 28 melted first, even if the external-use thermal fuse 29 has not melted.

The operation process above is based on the fact that whether fire has been set from outside or the fire has broken out from inside due to, for example, current leakage can be determined by determining which of an external temperature and an internal temperature reached a threshold temperature Th first, through (i) the fact that the external-use thermal fuse 29 and the internal-use thermal fuse 28 do not melt simultaneously and (ii) determining whether or not the internal-use thermal fuse 28 was melting when the external-use thermal fuse 29 melted.

Note that for each of the external-use thermal fuse 29 and the internal-use thermal fuse 28, an element having a melting temperature corresponding to a desired threshold temperature Th can be selected as appropriate from various commercially-available elements corresponding to various melting temperatures.

In comparison with the energy meter 1A in accordance with Embodiment 1 in which the internal measurement-use temperature sensor 25 and the external measurement-use temperature sensor 26 are used, the energy meter 1B in accordance with Embodiment 2, in which the external-use thermal fuse 29 and the internal-use thermal fuse 28 are used, makes it unnecessary to, for example, measure temperatures every 5 seconds. This advantageously allows the device and the operation process to be simple.

The energy meter 1B in accordance with Embodiment 2 is thus configured so that (i) the first threshold temperature detecting section includes: the internal-use thermal fuse 28 which serves as a first thermal fuse and which is configured to melt when the temperature of the first location of the energy meter main body 10 becomes equal to or higher than the threshold temperature Th serving as a first threshold temperature; and the determination data transmitting section 31b which serves as a third threshold temperature reaching transmitting section and which transmits, to the abnormality determination control section 13c serving as a determining section, information that the internal-use thermal fuse 28 has melted and (ii) the second threshold temperature detecting section includes: the external-use thermal fuse 29 which serves as a second thermal fuse and which melts when the temperature of the second location of the energy meter main body 10 becomes equal to or higher than the second threshold temperature; and the determination data transmitting section 31b which serves as a fourth threshold temperature reaching transmitting section and which transmits, to the abnormality determination control section 13c, information that the external-use thermal fuse 29 has melted.

Therefore, in a case where a thermal fuse which is a qualitative temperature measuring section is used, it is possible that, specifically, the abnormality determination control section 13c transmits a result of determination to an outside entity via the external communication section 14, the result determining which one of the following (i) and (ii) occurred before the other: (i) the temperature of the first location of the energy meter main body 10 became equal to or higher than the threshold temperature Th and (ii) the temperature of the second location became equal to or higher than the threshold temperature Th.

The present invention is not limited to the description of the embodiments above, but may be altered by a skilled person within the scope of the claims. Any embodiment based on a proper combination of technical means disclosed in different embodiments is also encompassed in the technical scope of the present invention. Further, it is possible to form a new technical feature by combining the technical means disclosed in the respective embodiments.

In order to attain the object, an energy meter in accordance with an aspect of the present invention is thus an energy meter in which power consumption is accumulated, including: a first threshold temperature detecting section configured to detect that a temperature of a first location inside an energy meter main body has become equal to or higher than a first threshold temperature which was set in advance; a second threshold temperature detecting section configured to detect that a temperature of a second location, which is located closer to a housing of the energy meter main body than is the first location, has become equal to or higher than a second threshold temperature; a determining section configured to determine, based on a result of detection by the first threshold temperature detecting section and a result of detection by the second threshold temperature detecting section, which one of the following (i) and (ii) occurred before the other: (i) the temperature of the first location became equal to or higher than the first threshold temperature and (ii) the temperature of the second location became equal to or higher than the second threshold temperature; and a transmitting section configured to transmit, to an outside entity, a result of determination by the determining section. In an aspect of the present invention, the transmitting section can transmit a result of the determination by the determining section to an outside entity, examples of the result encompassing (i) the fact that the temperature of the second location became equal to or higher than the second threshold temperature before the temperature of the first location became equal to or higher than the first threshold temperature and (ii) the fact that the temperature of the first location became equal to or higher than the first threshold temperature before the temperature of the second location became equal to or higher than the second threshold temperature. In addition, the second threshold temperature and the first threshold temperature can be identical or different.

A fraudulent activity of willfully burning an energy meter to destroy the display section on which an accumulated power consumption is displayed and accumulated power consumption data stored in the energy meter is committed for the purpose of electricity theft. Against such a fraudulent activity, it is important to identify that fire has been set from outside the energy meter.

Note that in a case where fire has been set from outside the energy meter and where the second threshold temperature and the first threshold temperature are identical, for example, the external temperature of the energy meter becomes equal to or higher than the threshold temperature first, and then the internal temperature of the energy meter becomes equal to or higher than the threshold temperature. On the other hand, in a case where the energy meter has burned because fire has broken out from inside due to current leakage or the like, the internal temperature of the energy meter becomes equal to or higher than the threshold temperature first, and then the external temperature of the energy meter becomes equal to or higher than the threshold temperature.

Therefore, in a case where the fact that the external temperature of the energy meter became equal to or higher than the threshold temperature before the internal temperature can be demonstrated, it is then possible to prove that the fraudulent activity of willfully burning the energy meter was committed.

Therefore, in a configuration in accordance with an aspect of the present invention, the first threshold temperature detecting section is configured to (i) detect that the temperature of the first location, which is located inside the energy meter main body, has become equal to or higher than the first threshold temperature which was set in advance and (ii) detect that the temperature of the second location, which is located closer to the housing of the energy meter main body, has become equal to or higher than the second threshold temperature. The temperature of the second location corresponds to the external temperature.

The determining section determines, based on a result of detection by the first threshold temperature detecting section and a result of detection by the second threshold temperature detecting section, which one of the following (i) and (ii) occurred before the other: (i) the temperature of the first location became equal to or higher than the first threshold temperature and (ii) the temperature of the second location became equal to or higher than the second threshold temperature. The result of the determination is transmitted by the transmitting section to an outside administrator or the like.

Consequently, even if data on, for example, power consumption charge stored inside the energy meter main body is deleted by the burning of the energy meter, an administrator of the energy meter obtains, through communication before the energy meter main body is burned out, the result of the determination as to which one of the following (i) and (ii) occurred before the other: (i) the temperature of the first location became equal to or higher than the first threshold temperature and (ii) the temperature of the second location became equal to or higher than the second threshold temperature.

Therefore, it is possible to provide an energy meter which (i) determines whether the fire has broken out from inside the energy meter or the fire has been set to the energy meter from outside and then (ii) retains the results of the determination.

Note that the administrator of the energy meter can file a claim for damages against a fraudster on the evidence of the results of the determination.

In another aspect of the present invention, the energy meter can be arranged, in the above aspect of the present invention, such that: the first threshold temperature detecting section includes a first temperature measuring section configured to periodically measure the temperature of the first location of the energy meter main body, a first threshold temperature determining section configured to determine whether or not the temperature of the first location has become equal to or higher than the first threshold temperature, and a first threshold temperature reaching transmitting section configured to transmit, to the determining section, information that the temperature of the first location has become equal to or higher than the first threshold temperature; and the second threshold temperature detecting section includes a second temperature measuring section configured to periodically measure the temperature of the second location of the energy meter main body, a second threshold temperature determining section configured to determine whether or not the temperature of the second location of the energy meter main body has become equal to or higher than the second threshold temperature, and a second threshold temperature reaching transmitting section configured to transmit, to the determining section, information that the temperature of the second location has become equal to or higher than the second threshold temperature.

Therefore, (i) the first threshold temperature detecting section includes the first temperature measuring section configured to periodically measure the temperature of the first location which is located inside the energy meter main body and (ii) the second threshold temperature detecting section includes the second temperature measuring section configured to periodically measure the temperature of the second location of the energy meter main body. This means that the first temperature measuring section and the second temperature measuring section are each configured by, for example, a temperature sensor. Therefore, the first temperature measuring section and the second temperature measuring section, each of which is constituted by a temperature sensor or the like, quantitatively measure temperatures. This (i) allows the first threshold temperature determining section to determine whether or not the temperature of the first location has become equal to or higher than the first threshold temperature and (ii) allows the second threshold temperature determining section to determine whether or not the temperature of the second location has become equal to or higher than the second threshold temperature.

Then, when the temperature of the first location becomes equal to or higher than the first threshold temperature or the temperature of the second location becomes equal to or higher than the second threshold temperature, information is transmitted by the first threshold temperature reaching transmitting section or by the second threshold temperature reaching transmitting section, respectively, to the determining section.

Therefore, in a case where a quantitative temperature measuring section is used, it is possible that, specifically, the determining section transmits a result of determination to an outside entity via the transmitting section, the result determining which one of the following (i) and (ii) occurred before the other: (i) the temperature of the first location became equal to or higher than the first threshold temperature and (ii) the temperature of the second location became equal to or higher than the second threshold temperature.

In another aspect of the present invention, the energy meter is preferably arranged, in the above aspect of the present invention, such that: the first threshold temperature reaching transmitting section configured to transmit, to the determining section, first temperature information including (i) the temperature of the first location thus measured and (ii) detection time at which the temperature of the first location was detected; the first temperature information thus transmitted to the determining section is transmitted to an outside entity by the transmitting section; the second threshold temperature reaching transmitting section configured to transmit, to the determining section, second temperature information including (i) the temperature of the second location thus measured and (ii) detection time at which the temperature of the second location was detected; and the second temperature information thus transmitted to the determining section is transmitted to the outside entity by the transmitting section.

Therefore, information to be transmitted includes both (a) the result of determining which one of the following (i) and (ii) occurred before the other one: (i) the temperature of the first location became equal to or higher than the first threshold temperature and (ii) the temperature of the second location became equal to or higher than the second threshold temperature and (b) detection times at which the respective temperatures of the first location and of the second location were detected. This allows an administrator to obtain specific information on changes in the temperature of the first location and in the temperature of the second location.

In another aspect of the present invention, the energy meter can be arranged, in the above aspect of the present invention, such that: the first threshold temperature detecting section includes a first thermal fuse configured to melt when the temperature of the first location of the energy meter main body becomes equal to or higher than the first threshold temperature and a third threshold temperature reaching transmitting section configured to transmit, to the determining section, information that the first thermal fuse has melted; and the second threshold temperature detecting section includes a second thermal fuse configured to melt when the temperature of the second location of the energy meter main body becomes equal to or higher than the second threshold temperature and a fourth threshold temperature reaching transmitting section configured to transmit, to the determining section, information that the second thermal fuse has melted.

Therefore, (i) the first threshold temperature detecting section includes the first thermal fuse which melts when the temperature of the first location of the energy meter main body has become equal to or higher than the first threshold temperature and (ii) the second threshold temperature detecting section includes the second thermal fuse which melts when the temperature of the second location of the energy meter main body has become equal to or higher than the second threshold temperature. This (i) allows the first thermal fuse to qualitatively recognize that the temperature of the first location of the energy meter main body has become equal to or higher than the first threshold temperature and (ii) allows the second thermal fuse to qualitatively recognize that the temperature of the second location of the energy meter main body has become equal to or higher than the second threshold temperature. Then, when the temperature of the first location of the energy meter main body becomes equal to or higher than the first threshold temperature or when the temperature of the second location of the energy meter main body becomes equal to or higher than the second threshold temperature, the third threshold temperature reaching transmitting section or the fourth threshold temperature reaching transmitting section, respectively, transmits information to the determining section.

Therefore, in a case where a thermal fuse which is a qualitative temperature measuring section is used, it is possible that, specifically, the determining section transmits a result of determination to an outside entity via the transmitting section, the result determining which one of the following (i) and (ii) occurred before the other: (i) the temperature of the first location of the energy meter main body became equal to or higher than the first threshold temperature and (ii) the temperature of the second location became equal to or higher than the second threshold temperature.

In another aspect of the present invention, the energy meter is preferably arranged, in the above aspect of the present invention, such that: the first threshold temperature detecting section is configured to detect, at intervals of 15 seconds or less, whether or not the temperature of the first location has become equal to or higher than the first threshold temperature; and the second threshold temperature detecting section is configured to detect, at intervals of 15 seconds or less, whether or not the temperature of the second location has become equal to or higher than the second threshold temperature.

In a case where fire is set to an energy meter, a rate of temperature rise per unit time is high. Therefore, unless the first threshold temperature detecting section and the second threshold temperature detecting section frequently detect temperatures, it is not possible to recognize which one of the following (i) and (ii) occurred before the other: (i) the temperature of the first location of the energy meter main body became equal to or higher than the first threshold temperature and (ii) the temperature of the second location became equal to or higher than the second threshold temperature.

Therefore, (i) the first threshold temperature detecting section detects, at intervals of 15 seconds or less, whether or not the temperature of the first location has become equal to or higher than the first threshold temperature and (ii) the second threshold temperature detecting section detects, at intervals of 15 seconds or less, whether or not the temperature of the second location has become equal to or higher than the second threshold temperature. This makes it possible to reliably determine which one of the following (i) and (ii) occurred before the other: (i) the temperature of the first location of the energy meter main body became equal to or higher than the first threshold temperature and (ii) the temperature of the second location became equal to or higher than the second threshold temperature.

In order to attain the object, an energy meter fire outbreak location identification method in accordance with an aspect of the present invention is a method of identifying whether a fire outbreak location of an energy meter in which power consumption is accumulated is (i) a first location inside an energy meter main body or (ii) a second location located closer to a housing of the energy meter main body than is the first location, including the steps of: (a) detecting that a temperature of the first location of the energy meter main body has become equal to or higher than a first threshold temperature which was set in advance; (b) detecting that a temperature of the second location of the energy meter main body has become equal to or higher than a second threshold temperature which was set in advance; (c) determining which one of the following (i) and (ii) occurred before the other: (i) the temperature of the first location became equal to or higher than the first threshold temperature and (ii) the temperature of the second location became equal to or higher than the second threshold temperature; and (d) transmitting, to an outside entity, a result of the step (c).

Therefore, it is possible to provide an energy meter and energy meter fire outbreak location identification method, each of which can (i) determine whether the fire has broken out from inside the energy meter or the fire has been set to the energy meter from outside and then (ii) retain the results of the determination.

### Reference Signs List

1A, 1B Energy meter
2 Housing
3 Display section
4 LED lamp
7 Circuit board
10 Energy meter main body
11 voltage-dividing circuit
12 Power supply circuit
13 First control device
13a Power amount calculating section
13b Display control section
13c Abnormality determination control section (determining section)
13d External communication control section
14 External communication section (transmitting section)
15 First storage section
20A, 20B Security sensor
25 Internal measurement-use temperature sensor (first threshold temperature detecting section, first temperature measuring section)
26 External measurement-use temperature sensor (second threshold temperature detecting section, second temperature measuring section)
27 Second storage section
28 Internal-use thermal fuse (first thermal fuse)
29 External-use thermal fuse (second thermal fuse)
30 Second control device
31 Data communication section
31a Sensor data acquiring section
31b Determination data transmitting section (first threshold temperature reaching transmitting section, second threshold temperature reaching transmitting section, third threshold temperature reaching transmitting section, fourth threshold temperature reaching transmitting section, first threshold temperature detecting section, second threshold temperature detecting section)
32 Sensor data determining section
32a Internal threshold temperature determining section (first threshold temperature detecting section)
32b External threshold temperature determining section (second threshold temperature detecting section)
D1 External temperature (temperature of second location)
D2 Internal temperature (temperature of first location)
Th Threshold temperature

## Claims

1. An energy meter (1A) in which power consumption is accumulated, comprising:
a first threshold temperature detecting section configured to detect that a temperature of a first location inside an energy meter main body (10) has become equal to or higher than a first threshold temperature which was set in advance;
a second threshold temperature detecting section configured to detect that a temperature of a second location, which is located closer to a housing (2) of the energy meter main body than is the first location, has become equal to or higher than a second threshold temperature;
a determining section (13c) configured to determine, based on a result of detection by the first threshold temperature detecting section and a result of detection by the second threshold temperature detecting section, which one of the following (i) and (ii) occurred before the other: (i) the temperature of the first location became equal to or higher than the first threshold temperature and (ii) the temperature of the second location became equal to or higher than the second threshold temperature; and
a transmitting section (31) configured to transmit, to an outside entity, a result of determination by the determining section (13c).

2. The energy meter (1A) as set forth in claim 1, wherein:
the first threshold temperature detecting section includes
a first temperature measuring section (25) configured to periodically measure the temperature of the first location of the energy meter main body (10),
a first threshold temperature determining section (32a) configured to determine whether or not the temperature of the first location has become equal to or higher than the first threshold temperature, and
a first threshold temperature reaching transmitting section configured to transmit, to the determining section, information that the temperature of the first location has become equal to or higher than the first threshold temperature; and
the second threshold temperature detecting section includes
a second temperature measuring section (26) configured to periodically measure the temperature of the second location of the energy meter main body (10),
a second threshold temperature determining section (32b) configured to determine whether or not the temperature of the second location of the energy meter main body has become equal to or higher than the second threshold temperature, and
a second threshold temperature reaching transmitting section configured to transmit, to the determining section, information that the temperature of the second location has become equal to or higher than the second threshold temperature.

3. The energy meter (1A) as set forth in claim 2, wherein:
the first threshold temperature reaching transmitting section configured to transmit, to the determining section, first temperature information including (i) the temperature of the first location thus measured and (ii) detection time at which the temperature of the first location was detected;
the first temperature information thus transmitted to the determining section is transmitted to an outside entity by the transmitting section;
the second threshold temperature reaching transmitting section configured to transmit, to the determining section, second temperature information including (i) the temperature of the second location thus measured and (ii) detection time at which the temperature of the second location was detected; and
the second temperature information thus transmitted to the determining section is transmitted to the outside entity by the transmitting section.

4. The energy meter (1A) as set forth in claim 1, wherein:
the first threshold temperature detecting section includes
a first thermal fuse (28) configured to melt when the temperature of the first location of the energy meter main body (10) becomes equal to or higher than the first threshold temperature and
a third threshold temperature reaching transmitting section configured to transmit, to the determining section (13c), information that the first thermal fuse (28) has melted; and
the second threshold temperature detecting section includes
a second thermal fuse (29) configured to melt when the temperature of the second location of the energy meter main body (10) becomes equal to or higher than the second threshold temperature and
a fourth threshold temperature reaching transmitting section configured to transmit, to the determining section (13c), information that the second thermal fuse (29) has melted.

5. The energy meter (1A) as set forth in claim 1, 2, or 3, wherein:
the first threshold temperature detecting section is configured to detect, at intervals of 15 seconds or less, whether or not the temperature of the first location has become equal to or higher than the first threshold temperature; and
the second threshold temperature detecting section is configured to detect, at intervals of 15 seconds or less, whether or not the temperature of the second location has become equal to or higher than the second threshold temperature.

6. A method of identifying whether a fire outbreak location of an energy meter (1A) in which power consumption is accumulated is (i) a first location inside an energy meter main body (10) or (ii) a second location located closer to a housing (2) of the energy meter main body (10) than is the first location, comprising the steps of:
(a) detecting (S10, S15, S19) that a temperature of the first location of the energy meter main body (10) has become equal to or higher than a first threshold temperature which was set in advance;
(b) detecting (S8, S13, S21) that a temperature of the second location of the energy meter main body (10) has become equal to or higher than a second threshold temperature which was set in advance;
(c) determining which one of the following (i) and (ii) occurred before the other: (i) the temperature of the first location became equal to or higher than the first threshold temperature and (ii) the temperature of the second location became equal to or higher than the second threshold temperature; and
(d) transmitting (S17, S23), to an outside entity, a result of the step (c).

## Patentansprüche

1. Energiemessvorrichtung, in der der Stromverbrauch akkumuliert wird, umfassend:
einen ersten
Schwellentemperaturerfassungsabschnitt, der so konfiguriert ist, dass er erfasst, dass eine Temperatur einer ersten Stelle innerhalb eines
Energiemessvorrichtungshauptkörpers gleich oder höher als eine erste Schwellentemperatur, die im Voraus eingestellt wurde, geworden ist;
einen zweiten
Schwellentemperaturerfassungsabschnitt, der so konfiguriert ist, dass er erfasst, dass eine Temperatur einer zweiten Stelle, die sich näher an einem Gehäuse des Energiemessvorrichtungshauptkörpers befindet als die erste Stelle, gleich oder höher als eine zweite Schwellentemperatur geworden ist;
einen Bestimmungsabschnitt, der so konfiguriert ist, dass er auf der Grundlage eines Ergebnisses der Erfassung durch den ersten Schwellentemperaturerfassungsabschnitt und eines Ergebnisses der Erfassung durch den zweiten Schwellentemperaturerfassungsabschnitt bestimmt, welches Ereignis der folgenden (i) und (ii) vor dem anderen aufgetreten ist: (i) die Temperatur der ersten Stelle wurde gleich oder höher als die erste Schwellentemperatur und (ii) die Temperatur der zweiten Stelle wurde gleich oder höher als die zweite Schwellentemperatur; und
einen Übertragungsabschnitt, der so konfiguriert ist, dass er ein Ergebnis der Bestimmung durch den Bestimmungsabschnitt an eine externe Einheit überträgt.

2. Energiemessvorrichtung nach Anspruch 1, wobei:
der erste Schwellentemperaturerfassungsabschnitt enthält
einen ersten Temperaturmessabschnitt, der so konfiguriert ist, dass er periodisch die Temperatur der ersten Stelle des Energiemessvorrichtungshauptkörpers misst,
einen Abschnitt zur Bestimmung der ersten Schwellentemperatur, der so konfiguriert ist, dass er bestimmt, ob die Temperatur der ersten Stelle gleich oder höher als die erste Schwellentemperatur geworden ist oder nicht, und
einen Sendeabschnitt für das Erreichen der ersten Schwellentemperatur, der so konfiguriert ist, dass er an den Bestimmungsabschnitt Informationen darüber sendet, dass die Temperatur der ersten Stelle gleich der oder höher als die erste Schwellentemperatur geworden ist; und
der zweite Schwellentemperaturerfassungsabschnitt enthält
einen zweiten Temperaturmessabschnitt, der so konfiguriert ist, dass er periodisch die Temperatur der zweiten Stelle des Energiemessvorrichtungshauptkörpers misst,
einen Abschnitt zur Bestimmung der zweiten Schwellentemperatur, der so konfiguriert ist, dass er bestimmt, ob die Temperatur der zweiten Stelle des Energiemessvorrichtungshauptkörpers gleich oder höher als die zweite Schwellentemperatur geworden ist oder nicht, und
einen Sendeabschnitt für das Erreichen der zweiten Schwellentemperatur, der so konfiguriert ist, dass er an den Bestimmungsabschnitt Informationen darüber sendet, dass die Temperatur der zweiten Stelle gleich der oder höher als die zweite Schwellentemperatur geworden ist.

3. Energiemessvorrichtung nach Anspruch 2, wobei:
der Sendeabschnitt für das Erreichen der ersten Schwellentemperatur so konfiguriert ist, dass er an den Bestimmungsabschnitt eine erste Temperaturinformation sendet, die (i) die so gemessene Temperatur der ersten Stelle und (ii) den Erfassungszeitpunkt, zu dem die Temperatur der ersten Stelle erfasst wurde, enthält;
wobei die so an den Bestimmungsabschnitt gesendete erste Temperaturinformation vom Sendeabschnitt an eine externe Einheit gesendet wird;
wobei der Sendeabschnitt für das Erreichen der zweiten Schwellentemperatur so konfiguriert ist, dass er an den Bestimmungsabschnitt eine zweite Temperaturinformation sendet, die (i) die so gemessene Temperatur der zweiten Stelle und (ii) die Erfassungszeit, zu der die Temperatur der zweiten Stelle erfasst wurde, enthält; und
wobei die so an den Bestimmungsabschnitt gesendete zweite Temperaturinformation vom Sendeabschnitt an die externe Einheit gesendet wird.

4. Energiemessvorrichtung nach Anspruch 1, wobei:
der erste Schwellentemperaturerfassungsabschnitt enthält
eine erste thermische Sicherung, die so konfiguriert ist, dass sie schmilzt, wenn die Temperatur an der ersten Stelle des Energiemessvorrichtungshauptkörpers gleich oder höher als die erste Schwellentemperatur wird, und
einen Sendeabschnitt für das Erreichen einer dritten Schwellentemperatur, der so konfiguriert ist, dass er an den Bestimmungsabschnitt die Information sendet, dass die erste thermische Sicherung geschmolzen ist; und
der zweite Schwellentemperaturerfassungsabschnitt enthält
eine zweite thermische Sicherung, die so konfiguriert ist, dass sie schmilzt, wenn die Temperatur an der zweiten Stelle des Energiemessvorrichtungshauptkörpers gleich oder höher als die zweite Schwellentemperatur wird, und
einen Sendeabschnitt für das Erreichen einer vierten Schwellentemperatur, der so konfiguriert ist, dass er an den Bestimmungsabschnitt die Information sendet, dass die zweite thermische Sicherung geschmolzen ist.

5. Energiemessvorrichtung nach Anspruch 1, 2 oder 3, wobei:
der erste Schwellentemperaturerfassungsabschnitt so konfiguriert ist, dass er in Intervallen von 15 Sekunden oder weniger erfasst, ob die Temperatur der ersten Stelle gleich oder höher als die erste Schwellentemperatur geworden ist oder nicht; und
der zweite Schwellentemperaturerfassungsabschnitt so konfiguriert ist, dass er in Intervallen von 15 Sekunden oder weniger erfasst, ob die Temperatur der zweiten Stelle gleich oder höher als die zweite Schwellentemperatur geworden ist oder nicht.

6. Verfahren zum Identifizieren, ob eine
Brandausbruchsstelle einer Energiemessvorrichtung, in der der Stromverbrauch akkumuliert wird, (i) eine erste Stelle innerhalb eines Energiemessvorrichtungshauptkörpers oder (ii) eine zweite Stelle, die sich näher an einem Gehäuse des Energiemessvorrichtungshauptkörpers befindet als die erste Stelle, ist, umfassend die folgenden Schritte:
(a) Erfassen, dass eine Temperatur der ersten Stelle gleich oder höher als eine erste Schwellentemperatur, die im Voraus eingestellt wurde, geworden ist;
(b) Erfassen, dass eine Temperatur der zweiten Stelle des Energiemessvorrichtungshauptkörpers gleich oder höher als eine zweite Schwellentemperatur, die im Voraus eingestellt wurde, geworden ist;
(c) Bestimmen, welches der folgenden Ereignisse (i) und (ii) vor dem anderen eingetreten ist: (i) die Temperatur der ersten Stelle wurde gleich oder höher als die erste Schwellentemperatur und (ii) die Temperatur der zweiten Stelle wurde gleich oder höher als die zweite Schwellentemperatur; und
(d) Senden eines Ergebnisses aus Schritt (c) an eine externe Einheit.

## Revendications

1. Compteur d'énergie (1A) dans lequel une puissance absorbée est accumulée, comprenant :
une première section de détection de température seuil configurée pour détecter qu'une température d'un premier emplacement à l'intérieur d'un corps principal de compteur d'énergie (10) est devenue supérieure ou égale à une première température seuil qui a été fixée à l'avance ;
une seconde section de détection de température seuil configurée pour détecter qu'une température d'un second emplacement, qui est situé plus près d'un boîtier (2) du corps principal de compteur d'énergie que ne l'est le premier emplacement, est devenue supérieure ou égale à une seconde température seuil ;
une section de détermination (13c) configurée pour déterminer, d'après un résultat de détection par la première section de détection de température seuil et un résultat de détection par la seconde section de détection de température seuil, lequel des événements (i) et (ii) suivants s'est produit avant l'autre : (i) la température du premier emplacement est devenue supérieure ou égale à la première température seuil et (ii) la température du second emplacement est devenue supérieure ou égale à la seconde température seuil ; et
une section de transmission (31) configurée pour transmettre, à une entité extérieure, un résultat de détermination par la section de détermination (13c).

2. Compteur d'énergie (1A) selon la revendication 1, dans lequel :
la première section de détection de température seuil comporte
une première section de mesure de température (25) configurée pour mesurer périodiquement la température du premier emplacement du corps principal de compteur d'énergie (10),
une première section de détermination de température seuil (32a) configurée pour déterminer si la température du premier emplacement est ou non devenue supérieure ou égale à la première température seuil, et
une première section de transmission d'atteinte de température seuil configurée pour transmettre, à la section de détermination, des informations indiquant que la température du premier emplacement est devenue supérieure ou égale à la première température seuil ;
et
la seconde section de détection de température seuil comporte
une seconde section de mesure de température (26) configurée pour mesurer périodiquement la température du second emplacement du corps principal de compteur d'énergie (10),
une seconde section de détermination de température seuil (32b) configurée pour déterminer si la température du second emplacement du corps principal de compteur d'énergie est ou non devenue supérieure ou égale à la seconde température seuil, et
une deuxième section de transmission d'atteinte de température seuil configurée pour transmettre, à la section de détermination, des informations indiquant que la température du second emplacement est devenue supérieure ou égale à la seconde température seuil.

3. Compteur d'énergie (1A) selon la revendication 2, dans lequel :
la première section de transmission d'atteinte de température seuil est configurée pour transmettre, à la section de détermination, des premières informations de température comportant (i) la température du premier emplacement ainsi mesurée et (ii) un moment de détection auquel la température du premier emplacement a été détectée ;
les premières informations de température ainsi transmises à la section de détermination sont transmises à une entité extérieure par la section de transmission ;
la deuxième section de transmission d'atteinte de température seuil est configurée pour transmettre, à la section de détermination, des secondes informations de température comportant (i) la température du second emplacement ainsi mesurée et (ii) un moment de détection auquel la température du second emplacement a été détectée ; et
les secondes informations de température ainsi transmises à la section de détermination sont transmises à l'entité extérieure par la section de transmission.

4. Compteur d'énergie (1A) selon la revendication 1, dans lequel :
la première section de détection de température seuil comporte
un premier fusible thermique (28) configuré pour fondre lorsque la température du premier emplacement du corps principal de compteur d'énergie (10) devient supérieure ou égale à la première température seuil et
une troisième section de transmission d'atteinte de température seuil configurée pour transmettre, à la section de détermination (13c), des informations indiquant que le premier fusible thermique (28) a fondu ; et
la seconde section de détection de température seuil comporte
un second fusible thermique (29) configuré pour fondre lorsque la température du second emplacement du corps principal de compteur d'énergie (10) devient supérieure ou égale à la seconde température seuil et
une quatrième section de transmission d'atteinte de température seuil configurée pour transmettre, à la section de détermination (13c), des informations indiquant que le second fusible thermique (29) a fondu.

5. Compteur d'énergie (1A) selon la revendication 1, 2, ou 3,
dans lequel :
la première section de détection de température seuil est configurée pour détecter, à des intervalles de 15 secondes ou moins, si la température du premier emplacement est ou non devenue supérieure ou égale à la première température seuil ; et
la seconde section de détection de température seuil est configurée pour détecter, à des intervalles de 15 secondes ou moins, si la température du second emplacement est ou non devenue supérieure ou égale à la seconde température seuil.

6. Méthode pour identifier si un emplacement de début d'incendie d'un compteur d'énergie (1A) dans lequel une puissance absorbée est accumulée est (i) un premier emplacement à l'intérieur d'un corps principal de compteur d'énergie (10) ou (ii) un second emplacement situé plus près d'un boîtier (2) du corps principal de compteur d'énergie (10) que ne l'est le premier emplacement,
comprenant les étapes de :
(a) détection (S10, S15, S19) qu'une température du premier emplacement du corps principal de compteur d'énergie (10) est devenue supérieure ou égale à une première température seuil qui a été fixée à l'avance ;
(b) détection (S8, S13, S21) qu'une température du second emplacement du corps principal de compteur d'énergie (10) est devenue supérieure ou égale à une seconde température seuil qui a été fixée à l'avance ;
(c) détermination de celui des événements (i) et (ii) suivants qui s'est produit avant l'autre :
(i) la température du premier emplacement est devenue supérieure ou égale à la première température seuil et
(ii) la température du second emplacement est devenue supérieure ou égale à la seconde température seuil ; et
(d) transmission (S17, S23), à une entité extérieure, d'un résultat de l'étape (c).
